# EUROPÄISCHE PATENTSCHRIFT

(11) **EP 3 084 960 B1**
(45) Veröffentlichungstag und Bekanntmachung des Hinweises auf die Patenterteilung: **05.08.2020**
(21) Anmeldenummer: 14809635.7
(22) Anmeldetag: 09.12.2014
(51) Int. Cl.: H03K 17/567, H01H 9/54, H01H 33/59

(54) **SCHALTVORRICHTUNG ZUM FÜHREN UND TRENNEN VON ELEKTRISCHEN STRÖMEN**
SWITCHING DEVICE FOR CONDUCTING AND INTERRUPTING ELECTRIC CURRENTS
DISPOSITIF DE COMMUTATION POUR LE PASSAGE ET LA COUPURE DE COURANTS ÉLECTRIQUES

(30) Priorität: 17.12.2013 DE 102013114259
(43) Veröffentlichungstag der Anmeldung: 26.10.2016
(73) Patentinhaber: Eaton Intelligent Power Limited, Dublin 4 (IE)
(72) Erfinder: SCHMITZ, Gerd, 53859 Niederkassel (DE); UEDELHOVEN, Marcel, 53945 Blankenheim (DE); MEISSNER, Johannes, 53129 Bonn (DE); WOHLANG, Michael, 53332 Bornheim (DE)
(74) Vertreter: Eaton IP Group EMEA
(86) Internationale Anmeldenummer: PCT/EP2014/077034
(87) Internationale Veröffentlichungsnummer: WO 2015/091105

(56) Entgegenhaltungen:
- EP-A2- 2 410 551
- US-A- 3 639 808
- US-A- 4 420 784
- US-A- 4 959 746
- US-A- 5 081 558
- US-A1- 2005 195 550
- VAN GELDER P ET AL: "Zero volt switching hybrid DC circuit breakers", INDUSTRY APPLICATIONS CONFERENCE, 2000. CONFERENCE RECORD OF THE 2000 IEEE 8-12 OCTOBER 2000, PISCATAWAY, NJ, USA,IEEE, Bd. 5, 8. Oktober 2000 (2000-10-08), Seiten 2923-2927, XP010521702, ISBN: 978-0-7803-6401-1

## Beschreibung

Die Erfindung betrifft eine Schaltvorrichtung zum Führen und Trennen von elektrischen Strömen und ein Schaltgerät mit einer derartigen Schaltvorrichtung.

Das gängige Schaltprinzip zum Schalten und Löschen höherer Ströme in Schaltgeräten besteht meist aus einer doppelt-unterbrechenden Kontaktanordnung, welche die dort entstehenden Schaltlichtbögen über Lichtbogenlaufschienen in einer Stapelanordnung aus Löschblechen in Form sog. Deion-Kammern führen. In diesen Kammern werden die Lichtbögen gekühlt und in mehrere Teillichtbögen aufgeteilt, was mit einer entsprechenden Vervielfachung der Lichtbogenspannung verbunden ist. Beim Erreichen der treibenden Spannung erlischt der Lichtbogen und der Stromkreis wird dadurch unterbrochen. Beim Schalten hoher Wechselströme wird die Lichtbogenlöschung meist durch dynamische magnetische Blasfelder unterstützt, welche durch geeignete Formgebung der Stromleiter innerhalb des Schaltgeräts gebildet werden. Zum Löschen von Gleichströmen werden dagegen meist magnetische Blasfelder eingesetzt, die in der Regel von einer Anordnung von Permanentmagneten erzeugt werden.

Anders als bei den gängigen seit langem im Markt befindlichen Wechselstrom-Schaltgeräten werden vergleichbar große Schaltgeräte zum Trennen von niederfrequenten Strömen z.B. bei 16 2/3 Hz sowie von Gleichströmen durch die geringere bzw. fehlende Periodizität des Strom-Nulldurchgangs entsprechend stärker belastet. Die hierdurch auftretende längere Lichtbogenbrenndauer sorgt für einen im Vergleich zu Wechselstrom-Schaltgeräten höheren Energiegehalt der Schaltlichtbögen. Dies führt zum einen zu einem stärkeren Abbrand an Kontaktmaterial, zum anderen zu einer entsprechend hohen thermischen Belastung innerhalb der Schaltkammer. Eine solche thermische Belastung kann das Isolationsvermögen innerhalb einer Schaltkammer reduzieren. Im Ergebnis kann dadurch die elektrische Lebensdauer des Schaltgeräts verringert werden.

Eine Möglichkeit zur Reduzierung der von Schaltlichtbögen ausgehenden Belastung eines Schaltgeräts bieten sog. Hybrid-Schalter. Bekannte Hybrid-Schalter, wie z.B. in der deutschen Offenlegungsschrift DE 103 15 982 A1 beschrieben, bestehen aus einer Parallelschaltung von einer elektromechanisch betätigten Hauptschalter-Kontaktanordnung mit einem Halbleiterschalter z.B. auf Basis eines leistungsstarken IGBTs (Insulated Gate Bipolar Transistor). Im eingeschalteten Zustand ist dieser hochohmig, so dass der Laststrom ausschließlich über die geschlossenen mechanischen Kontakte fließt. Beim Ausschaltvorgang wird der Halbleiterschalter in der Weise angesteuert, dass er für kurze Zeit niederohmig wird, so dass der durch den mechanischen Schalter fließende Lichtbogenstrom für kurze Zeit auf den Halbleiterschalter kommutiert; anschließend wird dieser wieder stromsperrend angesteuert, wodurch der im Halbleiter geführte Strom lichtbogenfrei schnell zu null geführt wird. Mit einer solchen Hybrid-Anordnung lässt sich die effektive Lichtbogenzeit und damit die Belastung des Schalters stark reduzieren.

Die meisten Hybridschalter benötigen zur Energieversorgung sowie zum Ansteuern der Halbleiterelektronik eine externe Energiequelle. Dieser Nachteil wird durch die in der deutschen Gebrauchsmusterschrift DE 20 2009 004 198 U1 beschriebenen Erfindung vermieden. Dies geschieht in der Weise, dass die zum Betrieb der Elektronik erforderliche Energie dem beim Öffnen des mechanischen Schalters entstehenden Lichtbogen entzogen wird. Gleichzeitig wird durch den Lichtbogenstrom ein Energiespeicher, vorzugsweise in Form eines Kondensators, aufgeladen, welcher dann die Steuerspannung zum lichtbogenfreien Abschalten der Leistungshalbleiter liefert. Der Schaltvorgang in einem solchen Hybridschalter impliziert somit immer die kurzzeitige Ausbildung eines Schaltlichtbogens zwischen den mechanischen Kontakten. Der Nachteil dieser Anordnung besteht jedoch zum einen in einer nach wie vor vorhandenen Belastung des Schaltgeräts durch einen - wenngleich aufgrund der deutlich verkürzten Lichtbogenzeit entsprechend reduzierten - Kontaktabbrand, zum anderen in einer - besonders im Fall höherer Ströme - bis zum Erreichen einer sicheren Spannungsverfestigung relativ langen Strombelastung des Leistungshalbleiters.

Bei der in der US-Patentanmeldung US 2005/0195550 A1 beschriebenen Schaltung wird zum Ansteuern des Halbleiterschalters die in der Spule des elektromagnetischen Antriebs gespeicherte Energie verwendet. Zum Öffnen der Kontakte des Schaltgeräts wird die Spannungsversorgung der Spule des Antriebs abgeschaltet. Hierbei gibt die Spule die von ihr gespeicherte Energie über eine Zener-Diode frei, die mit der Primärseite eines Übertragers gekoppelt ist. Die durch die Primärseite fließende elektrische Energie erzeugt auf der Sekundärseite des Übertragers eine entsprechende Spannung, die einen Strom durch einen Widerstand zur Strombegrenzung und über eine parallel zur Sekundärseite geschaltete Zener-Diode treibt, der den Halbleiterschalter einschaltet, der parallel zu den Kontakten des Schaltgeräts geschaltet ist und den Laststrom übernimmt. Der Halbleiterschalter wird hierbei schneller eingeschaltet, als die mechanischen Kontakte des Schaltgeräts geöffnet werden, so dass der Laststrom bereits im Augenblick der Öffnung der mechanischen Kontakte auf den Halbleiterschalter kommutieren kann. Hierdurch kann die Ausbildung eines Schaltlichtbogens zwischen den mechanischen Kontakten prinzipiell vermieden werden.

Eine Schaltvorrichtung zum Führen und Trennen von elektrischen Strömen mit den Merkmalen des Oberbegriffs von Anspruch 1 ist aus der europäischen Patentanmeldung EP 2 410 551 A2 bekannt.

Die US-Patentschrift US 3,639,808 beschreibt eine Kontaktschutzschaltung für ein Relais, dessen Spule mit einer Gleichspannung versorgt wird und dessen Kontakt eine Wechselspannung schaltet. Parallel zum Kontakt ist ein Triac geschaltet, der durch eine magnetisch mit der Relaisspule gekoppelte Spule gesteuert werden kann.

Aufgabe der vorliegenden Erfindung ist es, eine Schaltvorrichtung zum Führen und Trennen von elektrischen Strömen und ein Schaltgerät mit einer derartigen Schaltvorrichtung vorzuschlagen, welche die aus der in der US-Patentanmeldung US 2005/0195550 A1 bekannte Schaltung weiter verbessern.

Diese Aufgabe wird durch die Gegenstände der unabhängigen Ansprüche gelöst. Weitere Ausgestaltungen der Erfindung sind Gegenstand der abhängigen Ansprüche.

Ein der vorliegenden Erfindung zugrunde liegender Gedanke besteht darin, zwei in Reihe geschaltete mechanische Kontaktanordnungen und einen parallel zu einer der mechanischen Kontaktanordnungen geschalteten Halbleiterschalter einzusetzen, um einerseits die Entstehung von Lichtbögen beim Trennen eines elektrischen Stroms weitgehend zu vermeiden, und andererseits eine sichere galvanische Trennung, welche halbleiterbasierte Kontaktanordnungen grundsätzlich nicht besitzen, durch die zweite in Reihe geschaltete elektromechanische Kontaktanordnung zu gewährleisten.

Eine Ausführungsform der Erfindung betrifft nun eine Schaltvorrichtung zum Führen und Trennen von elektrischen Strömen mit einer ersten mechanischen Kontaktanordnung, einem Halbleiterschalter, der parallel zur ersten mechanischen Kontaktanordnung geschaltet ist, einer zweiten mechanischen Kontaktanordnung, die in Reihe zur ersten mechanischen Kontaktanordnung geschaltet ist, einer Hilfsspule, die galvanisch vom Stromkreis eines Schaltantriebs zum Bewegen von Kontakten der ersten und zweiten mechanischen Kontaktanordnung getrennt und mit einer Spule des Schaltantriebs elektromagnetisch derart gekoppelt ist, dass in ihr beim Abschalten der Spannungsversorgung des Schaltantriebs eine Spannung erzeugt wird, und einer Schaltelektronik, die zum An- und Abschalten des Halbleiterschalters ausgebildet ist und von der in der Hilfsspule beim Abschalten der Spannungsversorgung des Schaltantriebs erzeugten Spannung versorgt wird. Durch den parallel zur ersten mechanischen Kontaktanordnung geschalteten Halbleiterschalter kann die Dauer von beim Schalten entstehenden Lichtbögen reduziert werden. Weiterhin kann durch die galvanische Trennung der Spannungsversorgung der Schaltelektronik über die Hilfsspule eine hohe Spannungsfestigkeit bei entsprechender Auslegung der Hilfsspule erreicht werden, wodurch die Schaltelektronik besonders gut vor zu hohen Spannungen geschützt ist.

Die Hilfsspule kann um die Spule des Schaltantriebs gewickelt sein. Hierdurch kann eine besonders effiziente elektromagnetische Kopplung mit der Spule des Schaltantriebs erreicht werden, wodurch eine zuverlässige Spannungsversorgung der Schaltelektronik erhalten werden kann.

Die Schaltelektronik kann ausgebildet sein, den Halbleiterschalter anzuschalten, sobald sie mit einer Spannung von der Hilfsspule versorgt wird. Da in der Regel das mechanische Öffnen der Schaltkontakte der ersten mechanischen Kontaktanordnung länger dauert als die Bereitstellung der Spannungsversorgung der Schaltelektronik über die Hilfsspule, kann der Halbleiterschalter bereits vor dem Öffnen der Schaltkontakte angeschaltet werden, so dass eine Kommutierung des zu schaltenden elektrischen Stroms von der ersten mechanischen Kontaktanordnung auf den Halbleiterschalter weitgehend ohne Lichtbogenausbildung erfolgen kann.

Weiterhin kann ein Stromwandler zum Erfassen des Stromflusses durch den Halbleiterschalter und Erzeugen eines entsprechenden Signals vorgesehen sein, das der Schaltelektronik zugeführt wird, wobei die Schaltelektronik ausgebildet ist, abhängig vom zugeführten Signal den Halbleiterschalter abzuschalten. Dies ermöglicht eine Anpassung der Steuerung des Halbleiterschalters, insbesondere des Abschaltens, an gerätespezifische Schwankungen des zu schaltenden elektrischen Stroms. Vor allem kann das Abschalten des Halbleiterschalters besser an den tatsächlichen Stromfluss angepasst werden.

Beispielsweise kann die Schaltelektronik ausgebildet sein, den Halbleiterschalter nach Ablauf einer vorgegebenen Stromflusszeit nach Empfang des Signals vom Stromwandler abzuschalten. Sobald also durch den Stromwandler signalisiert wird, dass ein Strom über den angeschalteten Halbleiterschalter fließt, kann dieser Stromfluss zeitlich durch die Schaltelektronik begrenzt werden, um den Halbleiterschalter nicht zu lange durch den Stromfluss zu belasten. Die vorgegebene Stromflusszeit kann hierzu derart bemessen sein, dass nach Verlöschen eines sich zwischen den Kontakten der sich öffnenden zweiten mechanischen Kontaktanordnung auftretenden Schaltlichtbogens eine ausreichende Zeit zur Wiederverfestigung der Schaltstrecke der Reihenschaltung von erster und zweiter mechanischer Kontaktanordnung besteht.

Die erste und zweite mechanische Kontaktanordnung können zudem ausgebildet sein, vom Schaltantrieb derart zeitverzögert geöffnet zu werden, dass die zweite mechanische Kontaktanordnung erst nach einer definierten Zeitdauer nach dem Öffnen der ersten mechanischen Kontaktanordnung geöffnet wird. Durch diese verzögerte Kontaktöffnung kann die Entstehung eines Lichtbogens beim Öffnen der Kontakte der zweiten mechanischen Kontaktanordnung nahezu vermieden werden, wenn der Strom durch den Halbleiterschalter bereits innerhalb der definierten Zeitdauer zu Null geführt ist.

Eine weitere Ausführungsform der Erfindung betrifft außerdem ein Schaltgerät mit einer Schaltvorrichtung nach der Erfindung und wie hierin beschrieben und einem Schaltantrieb zum Bewegen von Kontakten der ersten und zweiten mechanischen Kontaktanordnung. Ein solches Schaltgerät kann insbesondere einen speziell modifizierten Magnetantrieb besitzen, bei dem eine Hilfsspule einer Schaltvorrichtung gemäß der Erfindung um die Antriebsspule gewickelt ist und eine Schaltelektronik versorgt, die einen Hybridschalter des Schaltgeräts ansteuert.

Weitere Vorteile und Anwendungsmöglichkeiten der vorliegenden Erfindung ergeben sich aus der nachfolgenden Beschreibung in Verbindung mit den in den Zeichnungen dargestellten Ausführungsbeispielen.

In der Beschreibung, in den Ansprüchen, in der Zusammenfassung und in den Zeichnungen werden die in der hinten angeführten Liste der Bezugszeichen verwendeten Begriffe und zugeordneten Bezugszeichen verwendet.

Die Zeichnungen zeigen in
Fig. 1 ein Blockschaltbild eines Ausführungsbeispiels einer Schaltvorrichtung mit einer Doppelkontaktanordnung gemäß der Erfindung; und
Fig. 2 ein Ausführungsbeispiel eines Magnetantriebs eines Schaltgeräts gemäß der Erfindung.

In der folgenden Beschreibung können gleiche, funktional gleiche und funktional zusammenhängende Elemente mit den gleichen Bezugszeichen versehen sein. Absolute Werte sind im Folgenden nur beispielhaft angegeben und sind nicht als die Erfindung einschränkend zu verstehen.

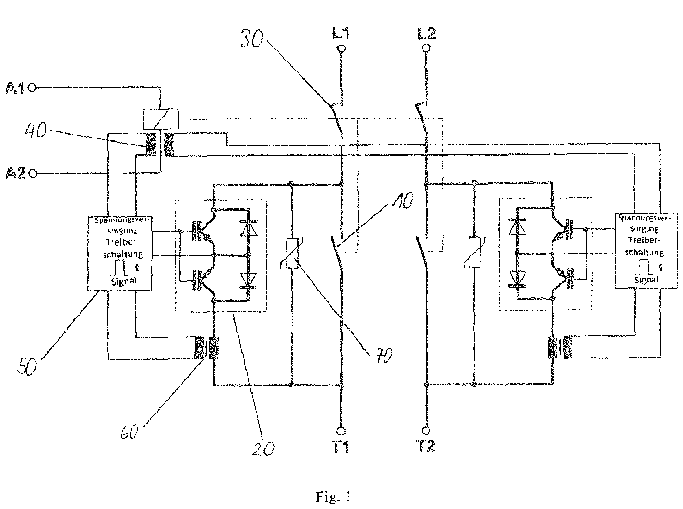

Fig. 1 zeigt das Blockschaltbild einer erfindungsgemäßen Schaltvorrichtung für ein 2-poliges, polaritätsunabhängiges Schaltgerät. Die Anschlüsse des Schaltgeräts für die beiden Pole sind jeweils mit L1, T1 und L2, T2 bezeichnet.

Für jeden Pol weist die Schaltvorrichtung eine Parallelschaltung einer ersten mechanischen (Lösch-)Kontaktanordnung 10 mit einem Halbleiterschalter 20 auf Basis einer antiseriellen IGBT-Anordnung auf, welche mit einer zweiten mechanischen Kontaktanordnung 30 zur Sicherstellung der galvanischen Trennung in Serie geschaltet ist.

Der Halbleiterschalter 20 wird von einer Schaltelektronik 50 an- oder abgeschaltet, d.h. durchgesteuert oder gesperrt. Die Schaltelektronik 50 wird von einer in der (Magnetantriebs-)Spule des Schalt- bzw. Magnetantriebs des Schaltgeräts gespeicherten Energie versorgt. Hierzu ist eine galvanisch vom Stromkreis des Schaltantriebs getrennte Hilfsspule 40 vorgesehen, welche - wie im Folgenden noch im Detail beschrieben wird - beim Abschalten des Schaltantriebs eine Spannung zum Versorgen der Schaltelektronik 50 erzeugen kann.

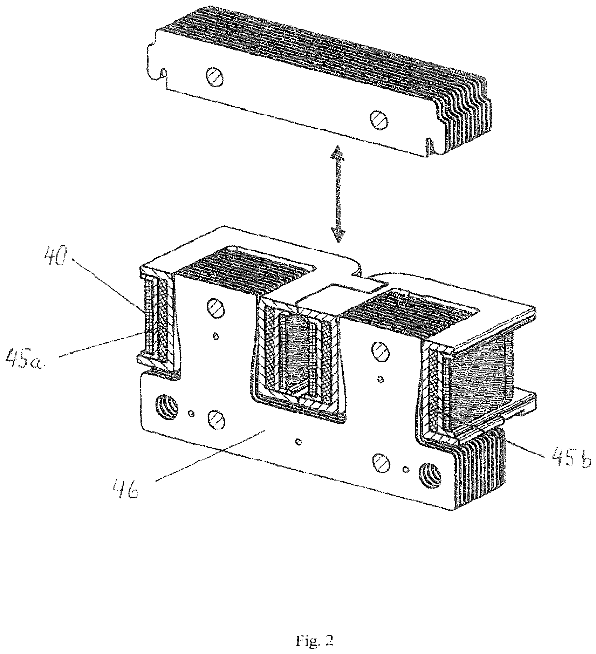

Die Hilfsspule 40 kann beispielsweise um die Antriebsspule gewickelt sein. In Fig. 2 ist ein solcherart modifizierter Magnetantrieb für einen 2-poligen oder auch mehrpoligen Schalter dargestellt (der dargestellte Antrieb als solcher ist nicht auf eine bestimmte Zahl von Polen beschränkt). Die Antriebsspule ist hier in Form zweier in Reihe geschalteter Halbspulen 45a, 45b ausgeführt, welche je einen Schenkel des U-förmigen Magnetkerns 46 umfassen. Jede dieser Halbspulen ist mit einer separaten Hilfsspule 40 umwickelt, welche gegen die jeweilige Antriebspule galvanisch getrennt ist. Eine Hilfsspule 40 versorgt hierbei entweder jeweils den Halbleiterschalter 20 eines Poles, oder beide Hilfsspulen 40 dienen der redundanten Versorgung der Schaltelektronik 50 beider Pole.

Im eingeschalteten Fall, d.h. wenn der Schaltantrieb die Magnetantriebs-Spule mit einer Spannung und einem Strom versorgt und die Kontakte der ersten und zweiten mechanischen Kontaktanordnungen 10 und 30 geschlossen sind, ist der Halbleiterschalter 20 gesperrt, da in diesem Zustand von der Hilfsspule 40 keine Spannung zum Versorgen der Schaltelektronik 50 erzeugt wird und die Schaltelektronik 50 daher spannungslos ist und die IGBTs des Halbleiterschalters 20 nicht ansteuern kann.

Im Moment des Abschaltens der Spannungs- und Stromversorgung der Magnetantriebs-Spule des Schaltantriebs zum Öffnen der Kontakte der ersten und zweiten mechanischen Kontaktanordnungen 10 und 30 erzeugt die in der Magnetantriebs-Spule gespeicherte Energie eine Freilaufspannung, die wiederum in der elektromagnetisch mit der Magnetantriebs-Spule gekoppelten Hilfsspule 40 eine Spannung induziert, welche die Schaltelektronik 50 aktiviert.

Die in der Hilfsspule 40 induzierte Spannung reicht aus, um zum einen die Schaltelektronik 50 selbst zu versorgen, zum anderen um die zum Ansteuern der IGBTs erforderliche Spannung aufzubauen. Die Hilfsspule 40 bietet den Vorteil, dass die Ansteuerung des Halbleiterschalters bereits vor Öffnung der Kontakte der ersten und zweiten mechanischen Kontaktanordnungen 10 bzw. 30 erfolgen kann.

Bei Schaltgeräten mit elektromechanischem Magnetantrieb beträgt der Zeitraum zwischen Initiierung des Abschaltvorgangs und dem Öffnen der mechanischen Kontakte in der Regel mehrere Millisekunden (ms), typischerweise rd. 10 ms. In dieser Zeit ist die Schwellspannung der IGBTs (typischerweise im Bereich 7V) durch die in der Hilfsspule 40 induzierte Spannung bereits überschritten, so dass die Schaltelektronik 50 diese auf die IGBTs des Halbleiterschalters 20 durchschalten kann, wodurch die IGBTs niederohmig geschaltet werden (der Halbleiterschalter 20 also angeschaltet wird) und der zu schaltende Laststrom mit dem Öffnen der (Lösch-)Kontakte der ersten mechanischen Kontaktanordnung 10 sofort auf den Halbleiterschalter 20 kommutiert.

Durch die vorauseilende Ansteuerung der IGBTs bildet sich zwischen den sich öffnenden Lösch-Kontakten der mechanischen Kontaktanordnung 10 somit kein Lichtbogen mehr aus. Während der niederohmigen Phase der IGBTs des Halbleiterschalters 20, also solange die Schaltelektronik 50 von der Hilfsspule 40 mit einer ausreichenden Betriebsspannung versorgt wird, kann sich lediglich zwischen den sich öffnenden (Trenn-)Kontakten der zweiten mechanischen Kontaktanordnung 30 für kurze Zeit ein Lichtbogen ausbilden; auch dieses lässt sich vermeiden, wenn die Trenn-Kontakte der zweiten mechanischen Kontaktanordnung 30 nicht zeitgleich mit den Lösch-Kontakten der ersten mechanischen Kontaktanordnung 10 öffnen, sondern die Öffnung der Trenn-Kontakte mit einer definierten zeitlichen Verzögerung gegenüber den Lösch-Kontakten erfolgt, was beispielsweise durch eine entsprechende mechanische Ausgestaltung der beiden mechanischen Kontaktanordnungen 10 und 30 bewerkstelligt werden kann.

Im Hinblick auf eine möglichst hohe elektrische Lebensdauer der IGBTs sowie auf deren vertretbar große Dimensionierung ist es zweckmäßig, den Stromfluss durch den Halbleiterschalter 20 zeitlich in der Weise zu begrenzen, dass der Strom dort nur so lange fließt, bis die mechanische Schaltstrecke eine ausreichende Wiederverfestigung erreicht hat. Für die Minimierung der Stromflusszeit durch den Halbleiterschalter 20 ist die genaue Kenntnis des Kommutierungszeitpunkts wichtig, da bei jedem Schaltgerät die effektiven Zeiten für den mechanischen Abschaltvorgang aus verschiedenen Gründen schwanken.

Gemäß der vorliegenden Erfindung kann der Zeitpunkt der Kommutierung auf den bereits durchgesteuerten IGBT des Halbleiterschalters 20 durch einen dort befindlichen Stromwandler 60 erfasst werden. Der Stromwandler 60 erzeugt ein Signal, sobald durch die IGBTs des Halbleiterschalters 20 ein Strom zu fließen beginnt, der Stromfluss also von der ersten mechanischen Kontaktanordnung 10 auf den Halbleiterschalter 20 kommutiert. Das vom Stromwandler 60 erzeugte und die Kommutierung signalisierende Signal wird der Schaltelektronik 50 zugeführt, die davon abhängig den Halbleiterschalter 20 wie im Folgenden beschrieben ansteuern kann.

Unmittelbar nach erfolgter Kommutierung kann die Schaltelektronik 50 den Halbleiterschalter 20 in der Weise ansteuern, dass die IGBTs des Halbleiterschalters 20 nach kurzer, über die Ansteuerelektronik definierter bzw. vorgegebener Stromflusszeit wieder sperrend werden, so dass der kommutierte Laststrom im Halbleiterschalter 20 innerhalb der definierten Zeitdauer zu null geführt wird. Die Stromflusszeit wird dabei über die Schaltelektronik 50 so bemessen, dass bei Ausbildung eines kurzzeitigen Schaltlichtbogens an den Trenn-Kontakten nach dessen Verlöschung eine ausreichende Zeit zur Wiederverfestigung der Schaltstrecke besteht. Dies ist vor allem bei Luftschaltstrecken für hohe Ströme wichtig. Bei Verwendung von Vakuumschaltkammern für die mechanische Trennung lassen sich vergleichbar kurze Wiederverfestigungszeiten erzielen, was für die Minimierung der Stromflusszeit in den IGBTs von Vorteil ist.

Durch die Ausstattung des Halbleiterschalters 20 mit einem antiseriellen IGBT ist eine solche Schaltanordnung sowohl für DC-Ströme mit beliebiger Stromflussrichtung als auf für Wechselspannungen unterschiedlicher Frequenz einsetzbar, wobei der Schaltzeitpunkt aufgrund der unabhängigen Versorgung des Ansteuermoduls nicht phasenwinkelabhängig ist.

Während des Abschaltvorgangs im Halbleiterschalter 20 kommt es bei hohen Strömen zu hohen dI/dt-Werten, wodurch Spannungsspitzen deutlich oberhalb 1 kV entstehen können. Zum Schutz vor solchen Spannungsspitzen ist es zweckmäßig, dem Halbleiterschalter 20 ein Schutzorgan, z.B. in Form eines Varistors 70 vorzuschalten oder parallel zu schalten.

Mit dem Erreichen des Strom-Null-Zustands wird der Halbleiterschalter 20 dauerhaft sperrend. Durch die inzwischen geöffneten Trenn-Kontakte 30 wird im Hybrid-Schalter gleichzeitig eine sichere galvanische Trennung hergestellt.

Wenn man über eine geeignete mechanische Kopplung oder auch auf elektronischem Weg dafür sorgt, dass die Lösch-Kontakte der ersten mechanischen Kontaktanordnung 20 den Trenn-Kontakten der zweiten mechanischen Kontaktanordnung 30 um die Zeit vorauseilen, in der der Halbleiterschalter 20 durchlässig ist, lässt sich erreichen, dass beide mechanischen Kontaktanordnungen 10 und 30 nahezu völlig lichtbogenfrei schalten, was für die Lebenserwartung der Schaltvorrichtung und insbesondere des Hybrid-Schalters von entsprechendem Vorteil ist.

Die vorliegende Erfindung eignet sich insbesondere zum Einsatz in Schützen, Leistungsschaltern und Motorschutzschaltern, die insbesondere für einen Betrieb mit Gleichströmen und/oder niederfrequenten Strömen ausgelegt sind. Sie ermöglicht das Schalten von hohen Gleichströmen und niederfrequenten Strömen bei einer vergleichsweise hohen elektrischen Lebensdauer, da lange Lichtbogenbrenndauern ebenso wie eine lange Strombelastung des Halbleiterschalters vermieden werden können. Weiterhin gestatten diese Eigenschaften die Realisierung von vergleichsweise kompakten Schaltgeräten für hohe Ströme.

### Bezugszeichen

- 10: erste mechanische Kontaktanordnung
- 20: Halbleiterschalter
- 30: zweite mechanische Kontaktanordnung
- 40: galvanisch getrennte Hilfsspule
- 45a: erste Halbspule
- 45b: zweite Halbspule
- 46: U-förmiger Magnetkern
- 50: Schaltelektronik
- 60: Stromwandler
- 70: Varistor

## Patentansprüche

1. Schaltvorrichtung zum Führen und Trennen von elektrischen Strömen mit
- einer ersten mechanischen Kontaktanordnung (10),
- einem Halbleiterschalter (20), der parallel zur ersten mechanischen Kontaktanordnung geschaltet ist,
- einer zweiten mechanischen Kontaktanordnung (30), die in Reihe zur ersten mechanischen Kontaktanordnung geschaltet ist, und
- einer Schaltelektronik (50), die zum An- und Abschalten des Halbleiterschalters (20) ausgebildet ist,
**dadurch gekennzeichnet, dass**
- eine Hilfsspule (40) vorgesehen ist, die galvanisch vom Stromkreis eines Schaltantriebs zum Bewegen von Kontakten der ersten und zweiten mechanischen Kontaktanordnung getrennt und mit einer Spule des Schaltantriebs elektromagnetisch derart gekoppelt ist, dass in ihr beim Abschalten der Spannungsversorgung des Schaltantriebs eine Spannung erzeugt wird,
- die Schaltelektronik (50) von der in der Hilfsspule beim Abschalten der Spannungsversorgung des Schaltantriebs erzeugten Spannung versorgt wird, und
- ein Stromwandler (60) zum Erfassen des Stromflusses durch den Halbleiterschalter und Erzeugen eines entsprechenden Signals vorgesehen ist, das der Schaltelektronik zugeführt wird, wobei die Schaltelektronik ausgebildet ist, abhängig vom zugeführten Signal den Halbleiterschalter abzuschalten.

2. Schaltvorrichtung nach Anspruch 1, **dadurch gekennzeichnet, dass** die Hilfsspule um die Spule des Schaltantriebs gewickelt ist.

3. Schaltvorrichtung nach Anspruch 1 oder 2, **dadurch gekennzeichnet, dass** die Schaltelektronik ausgebildet ist, den Halbleiterschalter anzuschalten, sobald sie mit einer Spannung von der Hilfsspule versorgt wird.

4. Schaltvorrichtung nach Anspruch 1, 2 oder 3, **dadurch gekennzeichnet, dass** die Schaltelektronik ausgebildet ist, den Halbleiterschalter nach Ablauf einer vorgegebenen Stromflusszeit nach Empfang des Signals vom Stromwandler, sobald also durch den Stromwandler signalisiert wird, dass ein Strom über den angeschalteten Halbleiterschalter fließt, abzuschalten, so dass dieser Stromfluss zeitlich durch die Schaltelektronik begrenzt wird, um den Halbleiterschalter nicht zu lange durch den Stromfluss zu belasten.

5. Schaltvorrichtung nach Anspruch 4, **dadurch gekennzeichnet, dass** die vorgegebene Stromflusszeit derart bemessen ist, dass nach Verlöschen eines zwischen den Kontakten der sich öffnenden zweiten mechanischen Kontaktanordnung auftretenden Schaltlichtbogens eine ausreichende Zeit zur Wiederverfestigung der Schaltstrecke der Reihenschaltung von erster und zweiter mechanischer Kontaktanordnung besteht.

6. Schaltvorrichtung nach einem der vorhergehenden Ansprüche, **dadurch gekennzeichnet, dass** die erste und zweite mechanische Kontaktanordnung ausgebildet sind, vom Schaltantrieb derart zeitverzögert geöffnet zu werden, dass die zweite mechanische Kontaktanordnung erst nach einer definierten Zeitdauer nach dem Öffnen der ersten mechanischen Kontaktanordnung geöffnet wird.

7. Schaltgerät mit
- einer Schaltvorrichtung nach einem der vorhergehenden Ansprüche und
- einem Schaltantrieb zum Bewegen von Kontakten der ersten und zweiten mechanischen Kontaktanordnung.

## Claims

1. Switching device for conducting and interrupting electrical currents having
- a first mechanical contact assembly (10),
- a semiconductor switch (20), which is connected in parallel with the first mechanical contact assembly,
- a second mechanical contact assembly (30), which is connected in series with the first mechanical contact assembly, and
- a switching electronics (50) which is designed to switch the semiconductor switch (20) on and off,
**characterised in that**
- an auxiliary coil (40) is provided, which is galvanically isolated from the circuit of a switching drive for moving contacts of the first and second mechanical contact assemblies and is electromagnetically coupled to a coil of the switching drive in such a way that a voltage is produced in said auxiliary coil when the voltage supply of the switching drive is switched off,
- the switching electronics (50) is supplied by the voltage produced in the auxiliary coil when the voltage supply of the switching drive is switched off, and
- a current transformer (60) is provided for detecting the current flow through the semiconductor switch and producing a corresponding signal, which is supplied to the switching electronics, wherein the switching electronics is designed to switch off the semiconductor switch depending on the signal supplied.

2. Switching device according to claim 1, **characterised in that** the auxiliary coil is wound around the coil of the switching drive.

3. Switching device according to claim 1 or 2, **characterised in that** the switching electronics is designed to switch on the semiconductor switch as soon as it is supplied with a voltage from the auxiliary coil.

4. Switching device according to claim 1, 2 or 3, **characterised in that** the switching electronics is designed to switch off the semiconductor switch after a specified current flow time has elapsed after receiving the signal from the current transformer, as soon therefore as it is signalled by the current transformer that a current flows via the switched on semiconductor switch, so that said current flow is limited in time by the switching electronics, in order not to load the semiconductor switch too long by the current flow.

5. Switching device according to claim 4, **characterised in that** the specified current flow time is dimensioned in such a manner that after extinguishing a switching arc that occurs between the contacts of the opening second mechanical contact assembly a sufficient time exists for reconsolidating the switching path of the series circuit of the first and second mechanical contact assembly.

6. Switching device according to any one of the preceding claims, **characterised in that** the first and second mechanical contact assembly are designed to be opened in a time-delayed manner by the switching drive in such a way that the second mechanical contact assembly is only opened after a defined time period after the opening of the first mechanical contact assembly.

7. Switchgear having
- a switching device according to any one of the preceding claims and
- a switching drive for moving contacts of the first and second mechanical contact assembly.

## Revendications

1. Dispositif de commutation pour la conduction et l'isolation de courants électriques avec
- un premier dispositif de contact mécanique (10),
- un interrupteur à semi-conducteur (20) connecté en parallèle avec le premier dispositif de contact mécanique,
- un second dispositif de contact mécanique (30) connecté en série avec le premier dispositif de contact mécanique, et
- une électronique de commutation (50) qui est conçue pour activer et désactiver l'interrupteur à semi-conducteur (20),
**caractérisé en ce que**
- une bobine auxiliaire (40) est prévue, qui est isolée électriquement du circuit électrique d'un entraînement de commutation pour le déplacement de contacts du premier et du second dispositif de contact mécanique et qui est couplée électromagnétiquement à une bobine de l'entraînement de commutation de sorte qu'une tension y est générée lorsque l'alimentation en tension de l'entraînement de commutation est désactivée,
- l'électronique de commutation (50) est alimentée par la tension générée dans la bobine auxiliaire lorsque l'alimentation en tension de l'entraînement de commutation est coupée, et
- un transformateur de courant (60) est configuré pour détecter le flux de courant à travers l'interrupteur à semi-conducteur et générer un signal correspondant qui est fourni à l'électronique de commutation, l'électronique de commutation étant conçue pour désactiver l'interrupteur à semi-conducteur en fonction du signal fourni.

2. Dispositif de commutation selon la revendication 1, **caractérisé en ce que** la bobine auxiliaire est enroulée autour de la bobine de l'entraînement de commutation.

3. Dispositif de commutation selon la revendication 1 ou 2, **caractérisé en ce que** l'électronique de commutation est conçue pour activer l'interrupteur à semi-conducteur dès qu'il est alimenté par une tension provenant de la bobine auxiliaire.

4. Dispositif de commutation selon la revendication 1, 2 ou 3, **caractérisé en ce que** l'électronique de commutation est conçue pour désactiver l'interrupteur à semi-conducteur après l'écoulement d'un temps de conduction de courant prédéterminé après la réception du signal du transformateur de courant, c'est-à-dire dès que le transformateur de courant signale qu'un courant passe par l'interrupteur à semi-conducteur activé, de sorte que ce flux de courant est limité dans le temps par l'électronique de commutation afin de ne pas charger trop longtemps l'interrupteur à semi-conducteur par le flux de courant.

5. Dispositif de commutation selon la revendication 4, **caractérisé en ce que** le temps de conduction de courant prédéterminé est tel qu'après l'extinction d'un arc électrique de commutation se produisant entre les contacts du second dispositif de contact mécanique d'ouverture, il y a suffisamment de temps pour reconsolider la section de commutation du montage en série des premier et second dispositifs de contact mécanique.

6. Dispositif de commutation selon l'une quelconque des revendications précédentes, **caractérisé en ce que** les premier et second dispositifs de contact mécanique sont conçus pour être ouverts par l'entraînement de commutation avec un retardement tel que le second dispositif de contact mécanique n'est ouvert qu'après une durée définie après l'ouverture du premier dispositif de contact mécanique.

7. Appareil de commutation avec
- un dispositif de commutation conforme à l'une quelconque des revendications précédentes, et
- un entraînement de commutation pour le déplacement de contacts des premier et second dispositifs de contact mécanique.
